Europäisches Patentamt

European Patent Office

Office européen des brevets

(19)

(11) **EP 1 000 949 A1**

(12) **EUROPEAN PATENT APPLICATION**
published in accordance with Art. 158(3) EPC

(43) Date of publication:
**17.05.2000 Bulletin 2000/20**

(51) Int. Cl.$^7$: **C07F 7/08**, H01L 21/208, H01L 21/316, G02B 6/12

(21) Application number: **98911047.3**

(22) Date of filing: **27.03.1998**

(86) International application number:
**PCT/JP98/01382**

(87) International publication number:
**WO 98/58936 (30.12.1998 Gazette 1998/52)**

(84) Designated Contracting States:
**DE FR GB**

(30) Priority: **20.06.1997 JP 16371897**
**30.10.1997 JP 29818797**

(71) Applicant: **Hitachi, Ltd.**
**Chiyoda-ku, Tokyo 101-8010 (JP)**

(72) Inventors:
 • **MIWA, Takao**
  **Hitachinaka-shi, Ibaraki 312-0011 (JP)**

 • **WATANABE, Akira-Kawauchi Jutaku 3-203**
  **Sendai-shi, Miyagi 980-0861 (JP)**
 • **ITOU, Osamu**
  **Sendai-shi, Miyagi 981-3215 (JP)**
 • **SUZUKI, Masao**
  **Hitachi-shi, Ibaraki 316-0024 (JP)**

(74) Representative:
 **Beetz & Partner**
 **Patentanwälte**
 **Steinsdorfstrasse 10**
 **80538 München (DE)**

(54) **ORGANOSILICON NANOCLUSTER AND PROCESS FOR PRODUCING THE SAME**

(57)    A composition of an organosilicon nanocluster and a method for manufacturing thereof are disclosed. Further; details of a thin-film of silicon and a thin-film of silicon oxide both produced from said organosilicon nanocluster, and an electronic device comprising the organosilicon nanocluster are also disclosed.

The organosilicon nanocluster is soluble in an organic solvent and a band gap of a solution thereof in the organic solvent is between 3 eV and 1.2 eV when determined with a Tauc plotting method.

FIG.1

EP 1 000 949 A1

## Description

TECHNICAL FIELD

The present invention relates to an organosilicon nanocluster compound, a method for manufacturing thereof, and an application thereof to an electronics device.

BACKGROUND ART

Intending to use an amorphous silicon as a material for a solar cell and a driving part in a TFT-LCD, studies for and attempts at practical applications have been made. The amorphous silicon, however, had big problems in production cost lowering thereof and in enlarging to an usable size thereof, because the amorphous silicon was produced with vapor phase method in the prior art of technology.

As an attempt at lowering production cost and enlarging usable size, an organic silane compound is put in a wide study for a high-performance organic material. Though many studies generally handled a polysilane with a linear chain for overcoming said problems, this material has a problem in stability. The polysilane, as one of candidates in the low-dimensioned silicone compound system, was expected to provide various needs with suitable semiconductor properties; but there is no effective means available for p-n control to date. As to a material in the mono-dimensioned system, even if foreign molecule such as phosphorus or boron is introduced into the skeleton of the principal chain in said material, only disappointing result was obtained. Because such introduction merely left a trap-site in said material. As for doping Lewis acid or Lewis base into said material, such doping results in a great reduction of the stability in said material. Further, the polysilane compound with linear chain cannot be used as a silicone precursor; because said polysilane compound vaporizes with decomposition of the principal chain therein which simultaneously occurs during a heating process for elimination of organic group from said compound.

A network polysilane is a polysilane compound that has a ramiform silicon chains and is soluble in an organic solvent permitting forming a thin-film easily. This thin-film, however, does not show any improved semiconductor performance compared with said linear chain compound system, because a substitutional organic group of side chain of said thin-film obstructs the carrier movement among silicon skeletons. The network-polysilane also permits forming a thin-film of amorphous silicon by a heating process because this material has a network structure that offers excellent thermal resistance. Said thin-film of amorphous silicon, however, has problems. That is: the performance thereof is poor compared with the properties in an original amorphous silicon because this thin-film includes much remaining substitutions of organic group; and there is no acceptable means for doping thereto with phosphorus or boron.

In contrast to these, a heat-treating process using t-butyroctasilacubane) as a precursor can produce an amorphous silicon with the same performance as customary given by the vapor phase method in the prior art of technology. However, because said t-butyroctasilacubane is a crystalline compound, the thin-film thereof is obtainable only by a vapor phase deposition method and the thickness of said film is not uniform enough.

As mentioned above, no processes was able to produce a thin-film of amorphous silicon in a simple and efficient manner.

In the integrated circuit industries on the other hand, the operating wavelength of irradiation ray in the photolithography is now shifting into shorter length for finer resolution to achieve higher integration. To date, the photolithography has used a g-ray (wavelength 436 nm) one of the characteristic rays generated typically from a mercury lamp for processing. But recently, an i-ray (wavelength 365 nm) is becoming in more wide use for more advantages in the finer resolution. These processing mainly use a photo resist, of which principal constituent is a high molecular organic compound that includes aromatic rings in its molecule.

A customary used photo resist was not suitable for the processing in the photolithography when the process uses an irradiation ray in the wavelength range shorter than 350 nm. Because such photo resist includes a high molecular organic compound as its principal constituent, this largely absorbs rays with their wavelengths 350 nm or shorter.

As for materials in the silicon system represented by $SiO_2$ are yet have problems in the production efficiency, because said materials require to use VCD equipment or the like for producing the thin-film of $SiO_2$. To overcome these problems, use of a coating type material belongs to the siloxane system called "spin-on-glass" (Hereafter this method is referred to as SOG.) can be considered as a solution. However, SOG has other kind of problem. The problem is that SOG cannot form a thin-film with a thickness less than "sub-micron", because its internal residual film stress appearing in a curing stage is large. Moreover, the other problem is that SOG tends to invite a cracking during machining process because of its poor workability.

The network polysilane has an excellent thermal resistance because of its network structure and can form a thin-film of silicon oxide by exposing to light rays or by heating. However, a dense film was hardly obtainable because much elimination of organic groups occurred during processing thereof.

In optical devices, the means for forming optical waveguides is an important technical subject to be solved. To date, polyimide or similar organic materials were used to produce an optical waveguide with high-transparency because there was no simple process other than using such materials. These organic materials, however, resulted in a large optical attenuation and in a poor performance stability. Further, an inferior workability of said material caused a rough finish of sidewalls in the dry etching process resulting in an obstruction against growing the optical devices for higher performance. As one of the solutions for this problem, a silicon network polymer was considered, but this material was finally not accepted. Because the silicon oxide film produced from said material showed low transparency, which was inadequate in performance for any of optical waveguides.

## DISCLOSURE OF INVENTION

The object of the present invention is to make it possible synthesizing an organosilicon nanocluster and to provide a simplified means for forming a thin-film pattern of silicon or a thin-film pattern of silicon oxide using said organosilicon nanocluster, further and to apply said thin-film of said organosilicon nanocluster to an electronic device or an optical device under aforementioned circumstances.

The summary of the present invention that solves aforementioned problems is as described below.

Said problems are solved with a silicon nanocluster which is soluble in an organic solvent. Said silicon nanocluster is a silicon having three-dimensioned structure; and the composition and characteristics thereof are described in:

> W.L. Wilson, P.F. Szajowski, L.E. Brus, Science 262,1242 (1993).,
> K.A. Littau, P.J.Szajowski, A.R. Muller, A.R. Kortan, and L.E. Brus, J. Phys. Chem. 97, 1224 (1993).,
> S. Furukawa and T. Miyasato, Jpn, J. Appl. Phys. 27, L2207 (1989).,
> T. takagi, H. Ogawa, Y. Yamazaki, A. Ishizaki, and T. Nalagiri, Appl. Phys. Lett. 56, 2379 (1990).,
> D. Zhang, R.M. Kolbas, P.D. Milewski, D.J. Lichtenwalner, A.I. Kingon, and J.M. Zavada, Appl. Phys. Lett. 65, 2684 (1994).,
> X. Chen, J. Zhao, G. Wang, X. Shen, Phys. Lett. 212, 285 (1996).

As to a silicon nanocluster that is soluble in an organic solvent, an organosilicon nanocluster can be listed.

Said organosilicon nanocluster is an organic silicon compound that is soluble in an organic solvent and is 3 eV to 1.2 eV in the band gap thereof when measure with a Tauc plotting method for the solution thereof in said solvent. Said Tauc plotting method is a customary measuring method that determines optical band gaps of amorphous semiconductors interpreting an electron spectrum thereof. In the optical absorption due to an optical transition among bands in an amorphous semiconductor, the relationship between an intensity of absorption and a photon energy are expressed by the following formula:

$$\alpha = k(E - E_0)^2 / E \text{ (k is constant)}$$

The optical band gap of a substance is determined as a reading at a point of intersection of a tangent line drawn on a characteristic curve of said substance plotted in the right-angled coordinates and the horizontal axis thereof. (Tatsuo SHIMIZU, On Amorphous Semiconductors, Baihuu-kan, Tokyo, Japan, 1994, p201.) The procedure for drawing said characteristic curve thereof is as follows. By plotting the photon energy of the substance in the horizontal axis and plotting the square root of the product between the intensity of absorption thereof and the photon energy thereof in the vertical axis; then said characteristic curve can be drawn in the right-angled cordinates. Then said tangent line on said curve can be drawn according to the nature of said curve at an appropriate point for the purpose.

Said organosilicon nanocluster is generally advantageous in practical use when a composition thereof is defined with the formula 1 shown below:

$$Si_x C_y H_z O_a \tag{1}$$

provided that;

$0.1x \leqq y \leqq 10x,$
$0.3x \leqq z \leqq 30x,$ and
$a \leqq 5x$

Said organosilicon nanocluster has a low solubility with an organic solvent when y is less than 0.1x, and results in a poor quality of a thin-film of silicon and of a thin-film of silicon oxide when y is more than 10x. Further, said organosilicon nanocluster has a low solubility in an organic solvent when z is less than 0.3x, and results of a poor quality of a thin-film of silicon and in thin-film of silicon oxide when z is more than 30x. Still further, said organosilicon nanocluster results in a poor quality of a thin-film of silicon and in thin-film of a silicon oxide when a is more than 5x. It however should be notable that the values of a within the range $a \leqq 0.5$ is suitable when a silicon thin-film is desired to be produced. The smaller the values for y, z, and a comparing with x in the formula 1 become, the smaller the band gap determined with a Tauc plotting method becomes. Thus, said band gap will finally be lowered to the same value in the silicon 1.2 eV though the preferable dissolution in the organic solvent may decrease.

On the other hand; the greater the values for y, z, and a comparing with x become, the larger the band gap becomes.

To achieve the object of the present invention, the band gap determined with a Tauc plotting method is preferred to be 1.5 eV or more from the viewpoint of the preferable dissolution. Further, said band gap is preferred to be 3 eV or less from the viewpoint of acceptable quality of both of the thin-film of silicon and the thin-film of silicon oxide produced therefrom.

Said organosilicon nanocluster in the present invention is obtained through a reaction between silane tetrahalide and an organic halide compound under the existence of an alkaline metal or an alkaline earth metal.

Said organosilicon nanocluster mentioned in the present invention is also obtained through a reaction between silane tetrahalide and an organic halide compound under the existence of an alkaline metal or an alkaline earth metal by giving successive treatment with hydrofluoric acid.

Said thin-film of silicon in the present invention is obtained by processing said organosilicon nanocluster either by heating at a temperature 200°C to 1000°C or by irradiating with a light ray both under the condition that no reaction with oxygen is assured. Further, said thin-film of silicon oxide in the present invention is obtained by the same processing mentioned above: heating or ligh-irradiating but under the condition that assures a reaction with oxygen.

Said thin-film of silicon and said thin-film of silicon oxide are usable for semiconductor devices such as solar cells, liquid crystal display devices, and integrated circuits. Because said thin-films have the same characteristics that are obtainable in the compounds produced by the vapor phase method since said films are produced from the silicon nanocluster.

The present invention is derived from a deep study on a synthesizing method for three-dimensioned silicon network polymers aiming at developing a thin-film of silicon and a thin-film of silicon oxide both for use for semiconductor devices. The present invention is characterized by a provision of an organic solution soluble chemical compound comprising (Si)4-Si bond and Si-R bond (where R is an organic group comprising carbon number of one or more). Important advantages of said compound may be; that forming a thin-film of silicon and a thin-film of silicon oxide are easy even under ordinary pressure, and that the thin-films of silicon and the thin-film of silicon oxide both produced by said process have an excellent performance. Said organosilicon nanocluster in the present invention is obtained through a reaction between silane tetrahalide and organic halide compound under the existence of an alkaline metal or an alkaline earth metal. This is interpreted that a reaction between a silicon nanocluster and an organic metal makes said silicon nanocluster soluble; wherein said former silicon nanocluster is a matter produced from a reaction in silane tertahalide, and said organic metal is a matter produced by a reaction of an organic halide compound with a metal. An organic group comprising larger carbon number shows a good dissolution; however, a soluble organosilicon nanocluster is also obtained using a methyl group as an organic group.

Therefore, there is no limitation in the composition of said organic group.

In the synthesizing thereof, it is possible to substitute silane trihalide or silane dihalide for a part of said silane tetrahalide. When the silane trihalide or silane dihalide is used in said process, an organosilicon nanocluster with very high dissolution will be produced. Using said silane trihalide or silane dihalide makes the size of said silicon nanocluster small. Therefore, it is preferable to control the substituting amount of said silane trihalide being less than the residual amount of said silane tetrahalide so that the nature of a silicon nanocluster may retained therewith. As to the silane dihalide, it is preferred to keep the amount thereof being less than 50% of said amount of the silane tetrahalide. An organosilicon nanocluster thus produced is soluble in an ordinary solvent like hydrocarbon, alcohol, ether, aromatic solvents, and polar solvents.

In obtaining a thin-film of silicon using said ogranosilicon nanocluster, it is preferred to synthesize under a condition with dehydration and deoxygenation avoiding contacting thereof with any compound that may generate oxygen while processing. Further, it is important to use a terminating agent that has no alkyl metal and no atomic oxygen at the time of synthesizing termination.

However, in general, said organosilicon nanocluster thus obtained may still involve atomic oxygen that is derived from oxygen, water, and said terminating agent involved in the processing system; because complete purging such atomic oxygen therefrom is difficult. This atomic oxygen is harmful because it forms a film of silicon oxide in the silicon film under producing. Treating said silicon nanocluster with a hydrofluoric acid, however, purges this atomic oxygen. Said treatment with the hydrofluoric acid easily produces an atomic-oxygen-free silicon nanocluster as a precursor to the thin-film of silicon. A fluorinated silicon nanocluster produced with fluoride treatment is stable against moisture and is suitable for a raw material for a thin-film of silicon.

No special limitation applies to said terminating agent in producing said thin-film of silicon oxide: putting the reaction liquid into solvent that is reactive to said silicon halide such as alcohol is enough.

A spin coating method, a dipping method, and other similar wet processing generally used for forming a thin-film can form a thin-film of said organosilicon nanocluster using a solution of said organosilicon nanocluster dissolved in a solvent properly chosen for processing purpose.

Said organosilicon nanocluster forms a thin-film of silicon by heating or irradiating with ultraviolet ray said organosilicon nanocluster in a substantially oxygen-free atmosphere or a reductional atmosphere. A combined processing of heating and ultraviolet ray irradiation is other possible application. Forming a thin-film of silicon comes from a thermal cracking of an organic component in said organosilicon nanocluster. Temperature at which said thermal cracking of the organic component occurs is dependent on both of the chemical construction thereof and the heating application time duration thereto; and the thermal cracking thereof begins at about 200°C when t-butyl base is used. The cracking in the most of organic groups including aromatic groups almost completes before processing temperature reaches 500°C though this temperature may vary depending on heating conditions. When heated over 500°C, said thin-film changes from an amorphous silicon into a crystal silicon and evaporation thereof begins at a temperature over 1500°C. This behavior is applicable for manipulation of characteristics of produced silicon by controlling heating temperatures. A crystal silicon portion increases when heated at temperatures between 600°C and 800°C; and a non-crystal silicon portion increases when heated at a lower temperature below said temperatures. This behavior enables controlling the band gaps of the thin-film intended to obtain. The band gap the thin-film of silicon can be controlled continuously from about 2.5 V to about 1.5 V by manipulating respective amount of the crystal portion and the non-crystal portion with regulating said heating temperatures.

Simultaneous doping while calcining is possible when said process uses a material comprising atomic phosphorus as an organic group in said silicon nanocluster. The doping is also possible by calcining the silicon nanocluster under the coexistence of a chemical compound desired to dope. In this process, ensuring a high polymer in the processing system involve an atomic status dopant in certain form assures said doping process effective.

Therefore, said thin-film of silicon is suitable for use for a thin-film transistor that a liquid crystal display uses and for a solar cell. Cost estimations for forming a thin-film of silicon using prior art of technology VCD process, and for the same but using said processing in the present invention showed that: the manufacturing cost of a circuit board for a 13 in. TFT liquid crystal display using said silicon nanocluster was one-third of a cost thereof in the prior art of technology. Further, another estimation with the same comparison condition for an amorphous solar cell showed that the manufacturing cost with the present invention was 50% of a cost with the prior art of technology.

Silicon oxide is obtained from said organosilicon nanocluster by heating treatment or irradiating treatment with ultraviolet ray both applied under oxidizing atmosphere. The temperature in said processing is preferred to be more than 200°C for efficient production of said thin-film of silicon oxide likewise in the case for producing a thin-film of silicon. However, if the temperature rises to 1500°C or more, an evaporation occurs. (A combined treatment of ultraviolet ray irradiation and heating may be a possible alternative process.)

Cracking of organic group substantially occurs in a temperature range between 200°C and 500°C. Therefore, controlling cracking temperature produces a thin-film of silicon or a thin-film of silicon oxide both partly retaining residual organic group. Said residual organic group produces an insulating thin-film having a dielectric constant of 3 or less. Using fluorinated alkyl group or fluorinated aryl group as said organic group assures said dielectric constant thereof bringing being further-lowering. In addition to this, controlling the amount of said residual organic group lowers the refractive index of the produced material. Larger amount of said residual organic group makes said refractive index lowered.

Said thin-film of silicon oxide is usable as an insulating layer for micro-electronics devices like integrated semiconductor circuits because of its excellent insulation characteristics and lower film stress.

In addition, said organosilicon nanocluster turns into a silicon oxide when irradiated with ultraviolet ray in an oxygen-existing atmosphere. Application of this behavior permits forming a circuit pattern by exposing to light rays. A portion of thin-film of organosilicon nanocluster turned into silicon oxide by irradiation of ultraviolet ray becomes insoluble in a solvent. Therefore, processing with a solvent after said irradiation develops a negative pattern theron. Heating after said irradiation permits forming a circuit pattern comprising silicon oxide for exposed portion and silicon for unexposed portion when such heating is applied in a substantially oxygen-free atmosphere or in a reductive atmosphere. Said thin-film of silicon oxide thus formed has high transparency with no absorption in long wavelengths 200 nm or more, because said thin-film uses a silicon nanocrystal. Therefore, said thin-film of silicon oxide in the present invention is suitable as a material for an optical waveguide. The realizing means for controlling refractive index of an oxide film is as described above. Thus said processing produces a circuit pattern with no rough side surface that appears in a dry etching method, and produces therefore a low attenuation optical waveguide which brings high-performance to optical devices. If a network polysilane is used, the produced device is not usable because it has poor transparency.

Above-mentioned heat treatment over said thin-film thereof produces a thin-film of silicon or a thin-film of silicon oxide; especially wherein the thin-film of silicon was obtainable only by the vapor phase method in the prior art of technology. The present invention is remarkable in that the technology in the present invention permits forming a pattern comprising an insulating layer portion and a semiconductor portion simply by processing with coating, exposing to light ray, and heating. Moreover, without relying on a dry etching process, a process that comprises a combination of exposing process and developing process, and if desired, combination further with heating process produces an optical waveguide, which has no rough surface giving an excellent pattern and therefore which is useful to high-performance optical devices.

BRIEF DESCRIPTION OF DRAWINGS

Fig. 1     shows a CP/MAS $^{29}$Si-NMR spectrum of an organosilicon nanocluster synthesized.

Fig. 2     shows a GPC elution curve of an organosilicon nanocluster.

Fig. 3     shows a visible ultraviolet absorption spectrum of an organosilicon nanocluster .

Fig. 4     shows a voltage versus current characteristic curve in a relation between an n⁻-type silicon substrate and a thin-film of amorphous silicon.

Fig. 5     illustrates a schematic construction of a cross section of a two-layer aluminum wiring formed on a silicon wafer.

Fig. 6     shows an FT-IR spectrum of an organosilicon nanocluster synthesized.
         Where,

         Curve-a:     processed     without     a hydrofluoric acid treatment,
         Curve-b: processed with a hydrofluoric acid treatment.

Fig. 7     shows an 1H-NMR spectrum of an organosilicon nanocluster synthesized.
         Where,

         Curve-a:     processed     without     a hydrofluoric acid treatment,
         Curve-b: processed with a hydrofluoric acid treatment.

Fig. 8     shows an XPS spectrum of an organosilicon nanocluster synthesized.
         Wherein,

         Curve-a:     processed     without     a hydrofluoric acid treatment,
         Curve-b: processed with a hydrofluoric acid treatment.

Fig. 9     shows a visible ultraviolet absorption spectrum of a thin-film formed using an organosilicon nanocluster synthesized.
         Where,

         Curve-a:     processed     without     a hydrofluoric acid treatment,
         Curve-b: processed with a hydrofluoric acid treatment.

Fig. 10     shows a relationship between heating temperatures and optical band gaps in a thin-film formed using an organosilicon nanocluster synthesized.

Fig. 11     shows a voltage versus current curve at a junction area between an n⁻-type silicon substrate and a thin-film of a p⁻-type amorphous silicon.

BEST MODE FOR CARRYING OUT THE INVENTION

Referring now to the embodiments, there describes details of the present invention.

(Embodiment 1)

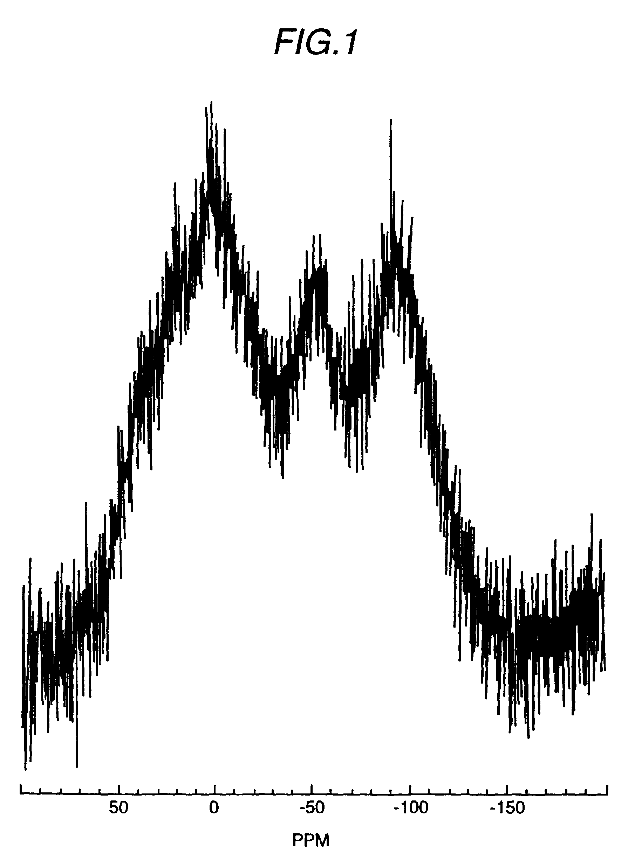

A solution prepared by solving a 16 m mol terachloro silane in tetrahydro furan was put in a reaction at 0°C for 3 h giving ultrasonic wave irradiation with coexistence of a metallic magnesium. After this treatment and then being added with a 16 m mol t -butyrbromide thereto, said solution was further put in a reaction at 50°C for 2 h. Said reaction solution thus treated produced a yellowish orange powder by pouring said reaction solution into methanol. (Hereafter said product is referred to as the matter A. The yield thereof was 43%.) The composition of said matter A determined with an elementary analysis and with a $^1$H-NMR was $Si_1C_{1.19}H_{3.07}O_{0.07}$, and the ratio of a butyl group and a methoxy group versus atomic silicon was 0.28 and 0.7 (PtBuSi1) respectively. Figure 1 shows a CP/MAS $^{29}$Si-NMR of said matter A. As can be seen from said Figure 1, a broad absorption exists at 15, 0, — 50, and — 95 ppm. These absorptions are assigned to the behavior of an atomic silicon which comprises Si-Si bonds of 1, 2, 3, and 4 in their number.

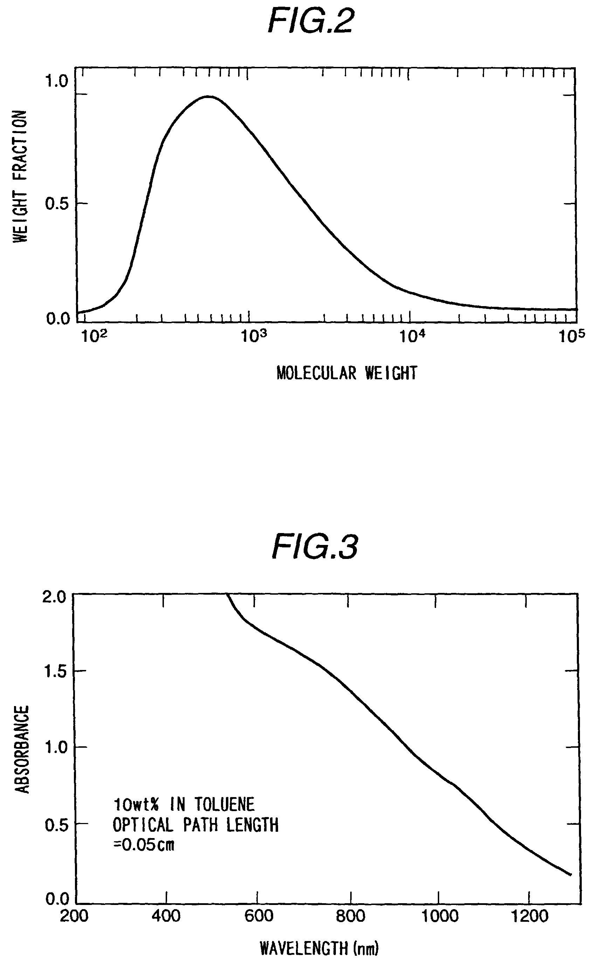

Molecular weight determination with GPC method using THF as an eluate therefrom showed a molecular weight of Mw = 1770 and Mw/Mn = 2.9 when converted into an equivalent amount of polystyrene. Figure 2 shows an elution curve. The end-to-end length of the standard polystyrene is 0.2 nm to 1.5 nm for the eluting range.

Figure 3 shows a visible ultraviolet absorption spectrum. Said spectrum is a result of examination for the case of a 0.5 mM THF solution. An absorption edge extended toward longer wavelengths than 400 nm comes form the non-crystal nature in said chemical compound. A band gap determined with a Tauc plotting method was 2.57 V. Said value 2.57 V is almost equal to that of the silicon nanoclrystal and the silicon nanocluster that are produced form a thermal cracking of a monosilane gas with a vapor phase method.

(Embodiment 2)

A thin-film formed on a quartz substrate with a spin coating method using a solution prepared by dissolving 1 g of said matter A in 10 g of toluene. After being dried at 100°C for 5 min, said thin-film was heated in a vacuum chamber ($2 \times 10^{-5}$ torr) for 1 h. Said thin-film was measured for a visible ultraviolet absorption spectrum after cooling down to a room temperature; then the Tauc plotting method thereon determined a band gap thereof being 1.8 ev when heated at 500°C and 1.6 eV when heated at 800°C.

(Embodiment 3)

A thin-film produced in the same manner as mentioned in Embodiment 2 was heated at 500°C in air. This processing formed a colorless transparent thin-film, which showed no absorption for wavelengths more than 200 nm in a visible ultraviolet absorption spectrum. The same experimental processing was applied on a silicon wafer substrate instead of said quartz substrate to form a thin-film thereon, which showed a high absorption near 950 $cm^{-1}$ in infrared absorption spectrum derived from stretching vibration generated by Si-O. This high absorption shows the evidence that a thin-film of silicon oxide formed thereon.

(Embodiment 4)

A solution prepared by solving a 16 m mol of tetrachloro silane in tetrahydro furan was put in a reaction at 0°C for 3 h giving ultrasonic wave irradiation with coexistence of metallic magnesium. After this treatment and then being added with a 16 m mol t -butyrbromide, said solution was further put in a reaction at 50°C for 2 h. Said solution was further put in a reaction at a room temperature for 12 h with addition of a 50 m mol solution of n-BuLi in hexane. Said reaction solution thus treated produced a yellowish orange powder by pouring said reaction solution into n-hexane. (Hereafter said product is referred to as the matter B. The yield thereof was 70%.) The composition of said matter B determined with an elementary analysis and with $^{1}$H-NMR was Si1C0.5H1.5.

(Embodiment 5)

The same experimental processing as mentioned in Embodiment 4 was applied to said solution but replacing metallic magnesium with metallic lithium, and the yield of produced powder in this processing was 75%. (Hereafter said product is referred to as the matter C.) The composition of said matter C determined with an elementary analysis and with a $^{1}$H-NMR was Si1C0.4H1.2. A band gap of a solution of the matter C was 2.4 eV when determined with Tauc plotting method based on a visible ultraviolet absorption spectrum obtained applying the same treatment in Embodiment 1.

(Embodiment 6)

The matter C was prepared in the same manner mentioned in Embodiment 2 and then said matter C was dried at 100°C for 5 min, which was followed by heating at 500°C for 1 h in a vacuum chamber (2×10$^{-}$

$^{3}$ torr). Said matter C was then cooled down to a room temperature and subsequently a band gap thereof was determined with the Tauc plotting method based on a visible ultraviolet absorption spectrum examination thereon; the determined band gap was 1.3 eV.

(Embodiment 7)

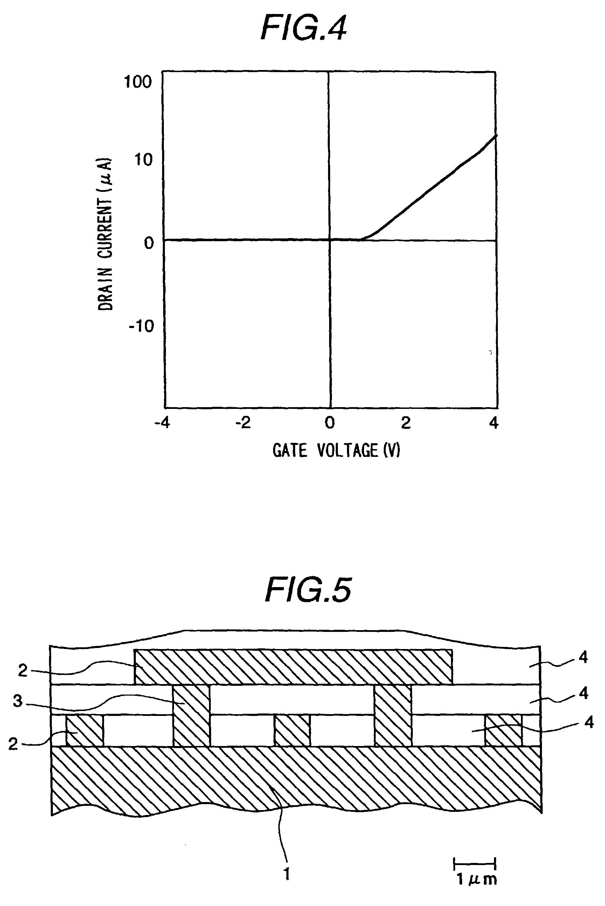

An organosilicon nanocluster was synthesized in the same manner mentioned in Embodiment 4 and then a 20% solution thereof in toluene was prepared. A thin-film of said organosilicon nanocluster was formed on an n$^{-}$-type silicon substrate with a spin coating method using said solution of the organosilicon nanocluster in toluene. Heating said thin-film of organosilicon nanocluster at 600°C in vacuum for 1 h produced a film of amorphous silicon. A doping thereto with phosphorus as an impurity formed a p-n junction between a thin-film of n$^{-}$-type silicon and a thin-film of p$^{-}$-type amorphous silicon. Two electrodes each having a length of 100 μm were formed on said amorphous silicon with a separation of 10 μm. Then a voltage versus current curve thereof was examined with a three-terminal method using one of said electrodes as a source electrode the other as drain electrode and said n-type substrate as a gate electrode. Figure 4 shows said voltage versus current curve.

(Embodiment 8)

An organosilicon nanocluster was synthesized in the same manner mentioned in Embodiment 1 and then a 30% solution thereof in toluene was prepared. Subsequent to said solution preparation; a film having a thickness of 2 μm was formed on a silicon wafer which has a pattern thereon composed of aluminum being given a dimension 1 μm to each of circuit width, circuit separation, and circuit height each formed with a spin coating method using a 30% solution of said organosilicon nanocluster in toluene. Said film thus processed was treated at 400°C in air for 1 h and then the surface of said film was polished to level by a chemomechanical polishing (CMP) method. The film with thus leveled surface showed no cracks even after such polishing; this means that a strong insulating film was produced. A withstanding voltage of said insulating film was 650 V/μm and the dielectric constant thereof was 3.4. Figure 5 schematically shows a cross section of a 2-layer circuit wired with aluminum applying above-mentioned processing. An aluminum wiring and a pier were formed by an ordinary etching method applied on aluminum deposited by a spattering method. Wiring processed on a silicon wafer on which transistors are formed produces an integrated circuit.

(Embodiment 9)

A thin-film was formed on a quartz substrate with a spin coating method using a solution of the matter A mentioned in Embodiment 1 in toluene. After a drying of said thin-film at 100°C for 5 min, the thin-film was exposed to a ray generated from 500 W high voltage mercury lamp for 3 min through a shading mask, and then developed with toluene. This process produced a smooth-surfaced pattern having a width of 1 μm and a thickness of 1 μm without pattern form deformation. This thin-film was found being suitable for an optical waveguide in a high performance optical device because said film has no absorption in longer wavelengths 200 nm or more.

(Embodiment 10)

A 64 m mol of metallic magnesium flake was heated in a round bottom flask at 120°C in vacuum to activate and then cooled down. After this activation, a dehydrated tetrahydro furan (THF) was added thereto keeping said reaction system in a nitrogen atmosphere. Said system was then put in a reaction at 0°C for 2.5 h by adding tetrachloro silane (16 m mol) thereto giving irradiation of ultrasonic waves (60 W) to produce a blackish brown reaction liquid. Said blackish brown reaction liquid was further kept reacting for 1 h by adding tert-butyrbromide) (16 m mol) thereto and then the reacting temperature thereof was raised to 50°C for a successive reaction for 0.5 h. On completion of duration of said reaction at 50°C for 0.5 h, an insoluble matter (Hereafter said product is referred to as the matter a.) was recovered by dropping said reaction liquid into distilled water followed by filtering.

Dispersing said matter a into a hydrofluoric acid of 47% concentration followed by filtering after agitation thereof for 30 min produced an insoluble matter (Hereafter said product is referred to as the matter b.).

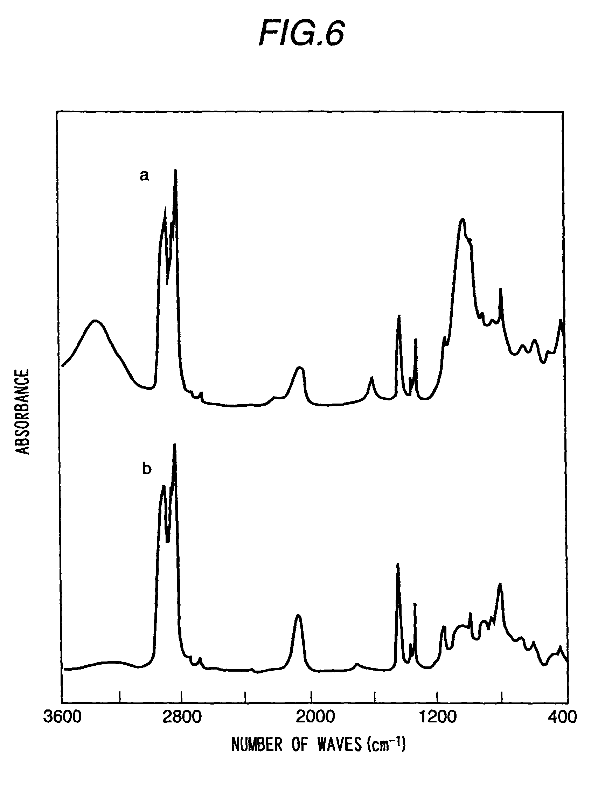

Figure 6 shows an FT-IR spectrum of said matters a and b. An absorption at 3370, 2855, 2080, and 1067 cm$^{-1}$ are assigned to a stretching vibration respectively in Si-OH, C-H (tert-Bu), Si-H, and Si-O (Si-O-Si and Si-OH). AS for said matter b, the FT-IR thereof shows no absorption that should be assigned to Si-OH and Si-O. A small absorption observed in an OH region is considered derived form water.

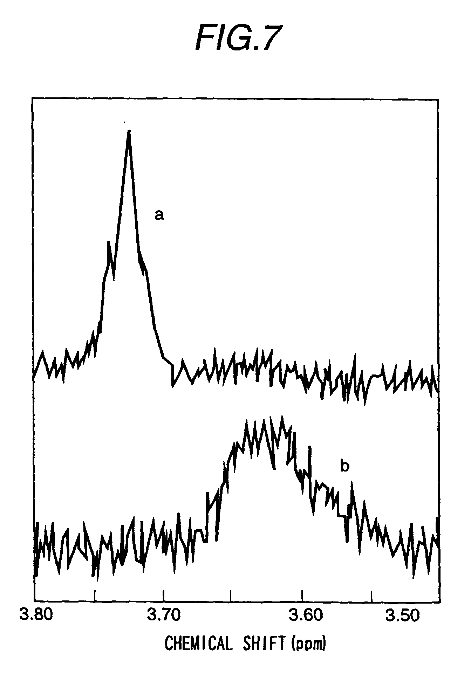

Figure 7 shows a 1H-NMR of said insoluble matters a and b. A spectrum for said matter a has an absorption at 3.73 ppm assigned to Si-OH. As for said matter b, there is no absorption at 3.73 ppm but there observed an absorption at 3.63 ppm assigned to Si-H.

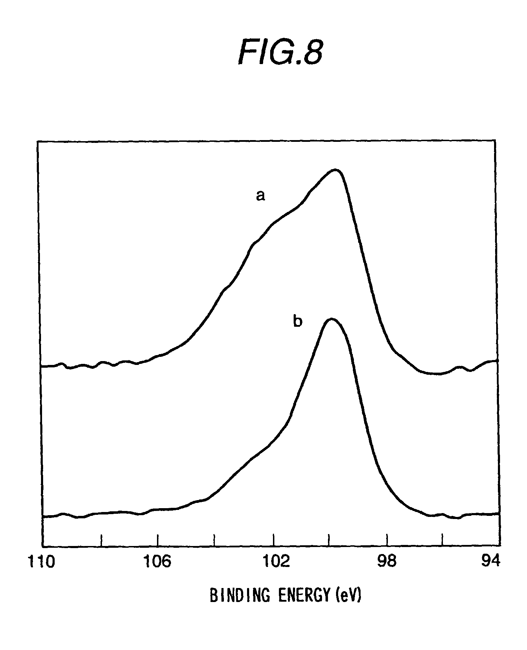

Figure 8 shows an XPS spectrum of said insoluble matters a and b. Said matter a shows a peak due to Si-O in the vicinity of 103 eV but said peak does not appear in said matter b. A peak at 1.2 eV is assigned to Si-C.

An elementary analysis confirmed that said matter b does not include oxygen.

(Embodiment 11)

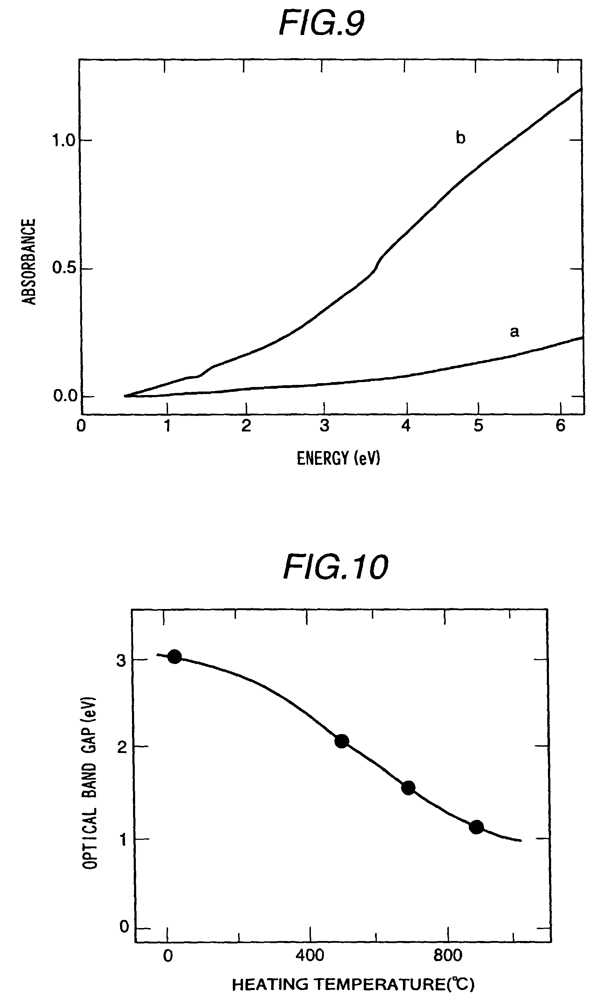

A solution A having a concentration of 16 wt% was prepared using toluene as a solvent and the matter a obtained in Embodiment 10 as a solute; likewise solution B using said matter b. Each solution is coated on a quartz substrate with a spin coating method of which revolution rate was regulated so as to control said coating thickness to be 1 μm and then said coating was dried on a hot plate at 80°C for 1 min. After drying, said coating was heated at 900°C for 1 h in vacuum (1×10$^{-5}$ torr). An ultraviolet absorption spectrum thereof was examined after cooling said coating down to a room temperature. Figure 9 shows said spectrum.

As can be seen from Figure 9, said solution B formed a-Si more efficiently than said solution A; because said solution B was larger than said solution A in absorption coefficient. An optical band gap determined by the Tauc plotting method based on said spectrum was that: 2.05 eV in solutions A and 1.20 eV in solution B. This 1.20 eV is equivalent to the optical band gap of a crystal silicon.

(Embodiment 12)

A thin-film was formed in the same manner as mentioned in Embodiment 11 using the matter B. Said thin-film was then heat treated varying temperatures from 400°C to 900°C, and then an optical band gap thereof was determined after each heat treatment at respective temperature. Said optical band gap determination used the Tacu plotting method based on an ultraviolet absorption spectrum measured thereon at room temperature. Figure 10 shows a relationship between said heat treatment temperatures and said optical band gaps. A value 1.64 eV at 700°C is equivalent to that of an amorphous silicon. A value 1.20 eV is equivalent to that of a crystal silicon.

(Embodiment 13)

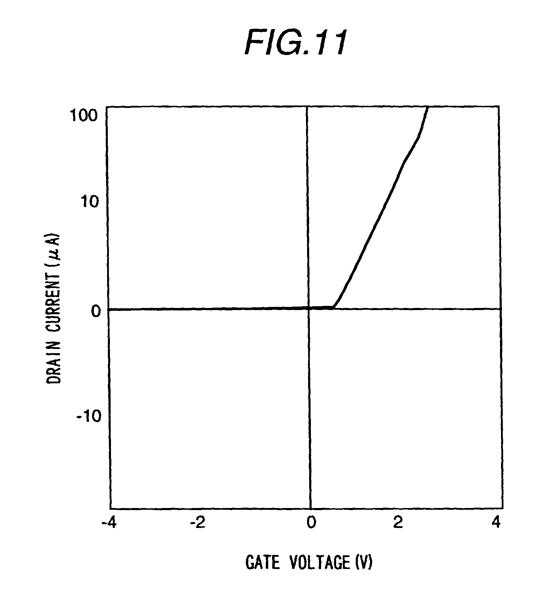

A thin-film of an organosilicon nanocluster was formed on an n⁻-type substrate with a spin coating method using the solution B. Heating said thin-film at 600°C for 1 h in vacuum produced a thin-film of amorphous silicon having a thickness of 0.3 μm. A doping thereto with phosphorus as an impurity formed a p-n junction between n⁻-type silicon and a thin-film of p⁻-type amorphous silicon. Then a voltage versus current characteristics thereof was examined in the same manner as mentioned in Embodiment 7. Figure 11 shows said voltage versus current characteristic curve, which shows a higher amplification factor than that in Figure 4. This appears that a SiO2 was formed due to existence of a trace of oxygen in said silicon nanocluster though such oxygen was not detected in the analysis for the case of Figure 4.

INDUSTRIAL APPLICATION

The present invention provides an organosilicon nanocluster and synthesizing means thereof. The present invention further provides a thin-film of silicon and a thin-film of silicon oxide both of which are derived form said organosilicon nanocluster, and further provides a high performance semiconductor device comprising said organosilicon nanocluster.

**Claims**

1.  A silicon nanocluster which is soluble in an organic solvent.

2.  A silicon nanocluster which is soluble in an organic solvent as set forth in Claim 1, wherein said silicon nanocluster consists of an organosilicon nanocluster, and wherein said organosilicon nanocluster is an organic silicon chemical compound that is soluble in an organic solvent, and a band gap of said solution thereof is between 3 eV and 1.2 eV when determined by a Tauc plotting method.

3.  An organic silicon chemical compound having the structural formula given as formula (1) below, soluble in an organic solvent, wherein a band gap of said solution thereof is between 3 eV to 1.22 eV when determined by a Tauc plotting method.

    $$SixCyHzOa \qquad (1)$$

    Where ranges for y, z, and a are specified as:

    $0.1x \leqq y \leqq 10x$,
    $0.3x \leqq z \leqq 30x$, and
    $a \leqq 5x$

4.  A method of manufacturing an organosilicon nanocluster, wherein a reaction process of silane tetrahalide with an organic halide compound is performed under the existence of an alkaline metal or an alkaline earth metal.

5.  A thin-film of silicon of which precursor is an organosilicon nanocluster.

6.  A method of manufacturing a thin-film of silicon, wherein an organosilicon nanocluster is heated at a temperature between 200°C and 1500°C under a condition that prevents said organosilicon nanocluster from reacting with oxygen.

7.  A method of manufacturing a thin-film of silicon as set forth in Claim 5, wherein an organosilicon nanocluster is heated at a temperature between 200°C and 1500°C under a reductional atmosphere.

8.  A method of manufacturing a thin-film of silicon oxide, wherein an organosilicon nanocluster is heated at a temperature between 200°C and 1500°C under a condition that permits said organosilicon nanocluster to react with oxygen.

9.  An electronic device comprising said thin-film of silicon as set forth in Claim 5.

10. A thin-film of silicon oxide of which precursor is an organosilicon nanocluster.

11. An electronic device comprising said thin-film of silicon oxide as set forth in Claim 10.

12. An optical waveguide comprising said thin-film of silicon oxide as set forth in Claim 10.

13. An optical device comprising said optical waveguide as set forth in Claim 12.

14. An organosilicon nanocluster processed by a reaction of silane tetrahalide with an organic halide compound under the existence of an alkaline metal or an alkaline earth metal and then a treatment with hydrofluoric acid. (Wherein: said organosilicon nanocluster is an organic silicon chemical compound that is soluble in an organic solvent, and a band gap of said solution thereof is between 3 eV and 1.2 eV when determined by a Tauc plotting method.)

15. A method of manufacturing an organosilicon nanocluster, which comprises the steps of; reacting silane tetrahalide with an organic halide compound under the existence of an alkaline metal or an alkaline earth metal, and then treating one with hydrofluoric acid.

16. A method of manufacturing a thin-film of silicon, which comprises the step of heating said organosilicon nanocluster as set forth in Claim 14 at a temperature between 200°C and 1500°C under a condition that prevents said organosilicon nanocluster from reacting with oxygen.

17. A method of manufacturing a thin-film of silicon, which comprises the step of heating said organosilicon nanoclusster as set forth in Claim 14 at a temperature between 200°C and 1500°C under a reductional atmosphere.

18. An organosilicon nanocluster being a chemical compound which is soluble in an organic solvent, and having a (Si)4-Si bond and a Si-R bond (where R is an organic group comprising carbon number of one or more).

19. An electronic device comprising said thin-film of silicon as set forth in Claim 16.

## FIG.1

PPM

## FIG.2

## FIG.3

# FIG.4

# FIG.5

# FIG.6

ABSORBANCE

3600   2800   2000   1200   400

NUMBER OF WAVES (cm⁻¹)

# FIG.7

CHEMICAL SHIFT (ppm)

# FIG.8

BINDING ENERGY (eV)

## FIG.9

## FIG.10

# FIG.11

# INTERNATIONAL SEARCH REPORT

International application No.

PCT/JP98/01382

A. CLASSIFICATION OF SUBJECT MATTER
Int.Cl⁶ C07F7/08, H01L21/208, 21/316, G02B6/12

According to International Patent Classification (IPC) or to both national classification and IPC

B. FIELDS SEARCHED

Minimum documentation searched (classification system followed by classification symbols)
Int.Cl⁶ C07F7/08, H01L21/208, 21/316, G02B6/12

Documentation searched other than minimum documentation to the extent that such documents are included in the fields searched

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP, 8-73472, A (Toa Gosei Co., Ltd.),<br>March 19, 1996 (19. 03. 96),<br>Claim 1 ; Par. Nos. [0001], [0007] (Family: none) | 1-3, 14, 18<br>4-13, 15-17,<br>19 |
| X<br>Y | JP, 63-68590, A (Mitsui Toatsu Chemicals, Inc.),<br>March 28, 1988 (28. 03. 88),<br>Claim 1 ; page 4, lower right column (3)<br>(Family: none) | 1-3, 14, 18<br>4-13, 15-17,<br>19 |
| X<br>Y | JP, 8-49088, A (Toa Gosei Co., Ltd.),<br>February 20, 1996 (20. 02. 96),<br>Claim 7 ; Par. No. [0050] (Family: none) | 1-3, 14, 18<br>4-13, 15-17,<br>19 |
| X<br>Y | JP, 4-264131, A (Nippon Telegraph & Telephone Corp.),<br>September 18, 1992 (18. 09. 92),<br>Object of the invention ; Claim 1 ; Par. Nos. [0001],<br>[0009] (Family: none) | 1-3, 14, 18<br>4-13, 15-17,<br>19 |

| ☒ | Further documents are listed in the continuation of Box C. | ☐ | See patent family annex. |

\* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>June 17, 1998 (17. 06. 98) | Date of mailing of the international search report<br>June 23, 1998 (30. 06. 98) |
|---|---|
| Name and mailing address of the ISA/<br>Japanese Patent Office | Authorized officer |
| Facsimile No. | Telephone No. |

Form PCT/ISA/210 (second sheet) (July 1992)

**INTERNATIONAL SEARCH REPORT**

| International application No. |
| --- |
| **PCT/JP98/01382** |

**C (Continuation). DOCUMENTS CONSIDERED TO BE RELEVANT**

| Category* | Citation of document, with indication, where appropriate, of the relevant passages | Relevant to claim No. |
| --- | --- | --- |
| Y | JP, 8-53471, A (Shin Etsu Chemical Co., Ltd.), February 27, 1996 (27. 02. 96), Claim 1 ; Par. No. [0010] & EP, 659754, A1 & US, 5498739, A | 4, 15 |
| Y | TAKAGI H., et al., "Quantum size effects on photoluminescence in ultrafine Si particles", Appl. Phys. Lett., No. 56, Vol. 24, 1990, p.2379-2380, Page 2380, right column, 15th line to 9th line from the bottom | 5-13, 16-17, 19 |
| A | ZHANG D., et al., "Light emission from thermally oxidized silicon nanoparticles", Appl. Phys. Lett., No. 65, Vol. 21, 1994, p.2684-2686, All references | 1-19 |
| A | JP, 3-123785, A (Yuki Gosei Kogyo Co., Ltd.), May 27, 1991 (27. 05. 91), All references (Family: none) | 1-19 |

Form PCT/ISA/210 (continuation of second sheet) (July 1992)